**Europäisches Patentamt**

(19) **European Patent Office**

**Office européen des brevets**

(11) Numéro de publication: **0 070 063**

**B1**

(12) **FASCICULE DE BREVET EUROPÉEN**

(45) Date de publication du fascicule du brevet:
**08.04.87**

(51) Int. Cl.⁴: **G 06 F 1/02**, H 03 M 1/80

(21) Numéro de dépôt: **82200813.2**

(22) Date de dépôt: **30.06.82**

(54) Générateur de fonction utilisant des commutateurs analogiques de courant en technologie bipolaire à injection.

(30) Priorité: **03.07.81 FR 8113141**

(43) Date de publication de la demande:
**19.01.83 Bulletin 83/3**

(45) Mention de la délivrance du brevet:
**08.04.87 Bulletin 87/15**

(84) Etats contractants désignés:
**DE FR GB IT**

(56) Documents cité:
**FR-A-2 316 804**

**SIEMENS FORSCHUNGS- & ENTWICKLUNGS-BERICHTE, vol. 9, no. 1, 1980, pages 41-46, Springer Verlag, Berlin (DE); W. UMKEHRER et al: "Verlustarme grossintegrierte Matrixbausteine in I2L-Technik"**
**H.R. SCHLEGEL: "Der Transistor", Siegfried Schütz Verlag Hannover 1959, pages 110-112**

(73) Titulaire: **TELECOMMUNICATIONS RADIOELECTRIQUES ET TELEPHONIQUES T.R.T., 88, rue Brillat Savarin, F-75013 Paris (FR)**

(84) Etats contractants désignés: **FR**

(73) Titulaire: **N.V. Philips' Gloeilampenfabrieken, Groenewoudseweg 1, NL- 5621 BA Eindhoven (NL)**

(84) Etats contractants désignés: **DE GB IT**

(72) Inventeur: **Pelletier, Joel, SOCIETE CIVILE S.P.I.D. 209 rue de l'Université, F-75007 Paris (FR)**
Inventeur: **Breuillard, Robert, SOCIETE CIVILE S.P.I.D. 209 rue de l'Université, F-75007 Paris (FR)**

(74) Mandataire: **Charpail, François, Société Civile S.P.I.D. 209, rue de l'Université, F-75007 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

# 0 070 063

## Description

L'invention concerne un generateur de fonction utilisant des commutateurs analogiques de courant en technologie bipolaire a injection dans lequel les niveaux successifs d'échantillonnage synthétisés sont approximés à partir des niveaux calculés multipliés par un certain facteur pour que les différences successives desdits niveaux synthétisés aient pour valeurs des nombres entiers aisément reproduits par une fonction alphanumérique dont les coefficients de pondération littéraux peuvent prendre les valeurs 0 et/ou 1, lesdites différences de niveaux s'ajoutant successivement dans les zones croissantes de la fonction et se retranchant dans les zones décroissantes de manière à reconstituer une variation approchée de ladite fonction.

La détermination de cette fonction à partir de la variation temporelle desdits coefficients de pondération implique une conversion numérique-analogique qui peut être réalisée au moyen de commutateurs analogiques.

Le document FR-A- 2 316 804 décrit des dispositifs semiconducteurs à logique d'injection plurivalente dans lesquels les sorties de signaux sont sur les collecteurs des transistors commutateurs. Ces dispositifs sont combinés pour former des structures intégrées logiques (portes ET, portes OU, circuits d'addition, etc...). Mais on peut les utiliser d'une nouvelle manière, par exemple pour former lesdits commutateurs analogiques en vue de commuter vers une sortie differents courants dont les intensités prennent différents poids.

La présente invention vise à concrétiser cette nouvelle utilisation des portes I²L dans la réalisation dudit générateur de fonction sous la forme d'une structure intégrée.

Selon l'invention, un ensemble d'éléments commutateurs analogiques de courant identiques constituant un convertisseur numérique-analogique a ses entrées de signal interconnectées sur une source unique de courant 1, de sorte que chacun d'eux reçoit le courant $i_e$, ledit convertisseur recevant les signaux de variation en fonction du temps desdits coefficients de pondératon et fournissant sur les sorties de signal interconnectées desdits commutateurs la somme pondérée des courants $\Sigma i_e$ proportionnelle auxdites différences de niveaux synthétisés, ladite somme pondérée étant transmise a un circuit de transformation qui reçoit des signaux pour l'affecter des signes + ou - selon que la différence entre deux niveaux synthétisés consécutifs est positive ou négative, la sommation des sommes pondérées successives $\Sigma(\pm \Sigma i_e)$ étant effectuée aux bornes d'une charge capacitive pour reconstituer un signal analogique proportionnel à ladite fonction.

Lesdits éléments commutateurs analogiques de courant sont des portes I²L dans lesquelles le transistor commutateur a son collecteur rétrocouplé sur sa base, l'entrée de signal étant sur l'émetteur du transistor injecteur et la sortie de signal à l'interconnexion de la base du transistor injecteur et de l'émetteur du transistor commutateur.

La description suivante en regard des dessins annexés, le tout donné à titre d'exemple fera bien comprendre comment l'invention peut être réalisée.

La figure 1 illustre l'échantillonnage de la fonction sinusoïdale.

La figure 2 donne en fonction du temps la variation des signaux numériques résultant de cet échantillonnage.

La figure 3 représente le schéma d'un élément commutateur analogique de courant en technologie bipolaire à injection utilisé dans le générateur de fonction.

La figure 4 montre le schéma d'un commutateur constitué par la mise en cascade de n éléments commutateurs identiques conformes au schéma de la figure 3.

La figure 5 représente le schéma d'un générateur de fonction conforme à l'invention.

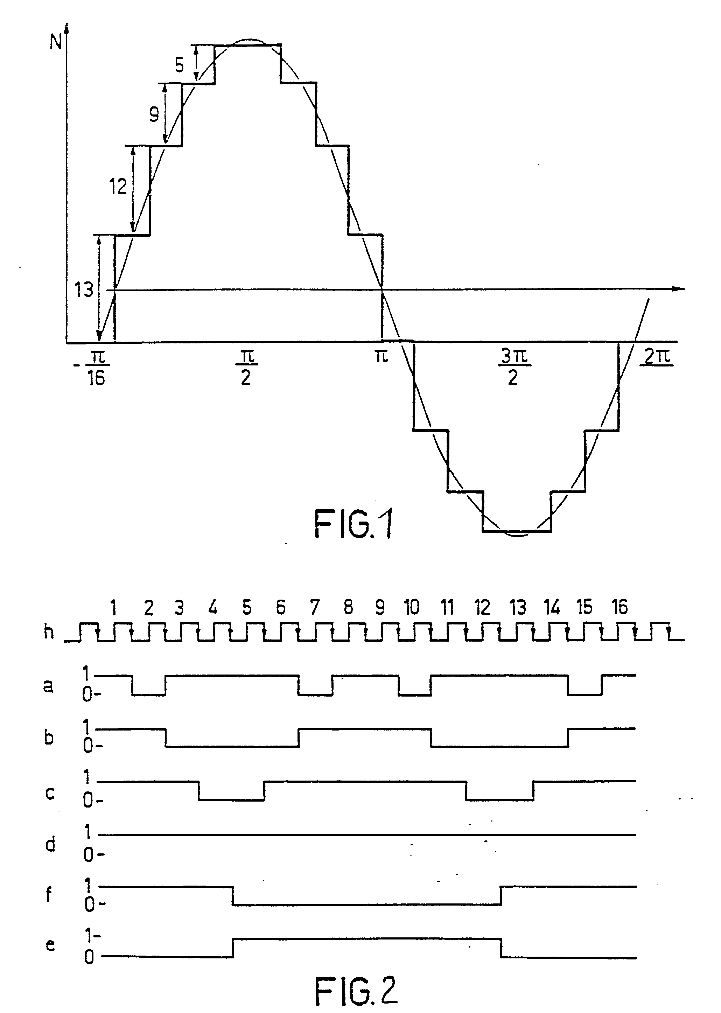

La figure 1 représente à titre d'exemple la variation de niveaux synthétisés de la fonction sinusoïdale avec la variable angulaire mise sous la forme $\pi/16 + K \pi/8$, K étant un nombre entier positif ou négatif. Ces niveaux synthétisés sont obtenus à partir du tableau ci-dessous de la façon suivante. La deuxième colonne de ce tableau donne les valeurs de $\sin(\pi/16 + K \pi/8)$ pour K = 0, 1, 2 et 3. On a inscrit dans la troisième colonne les niveaux calculés de la fonction obtenus en multipliant les différentes valeurs de $\sin(\pi/16 + K \pi/8)$ par le facteur 33,3 et dans la quatrième colonne du tableau les niveaux synthétisés correspondants avec le chiffre des dixiémes approximé à 5. De cette façon, si l'on se fixe une origine à - $\pi/16$ (K = - 1), les différences des niveaux synthétisés successifs ont pour valeurs les nombres entiers 13, 12, 9 et 5 qui peuvent être reproduits au moyen de la fonction a + b.4 + c.4 + d.4 dans laquelle a, b et c peuvent prendre les valeurs 0 ou 1 et d la valeur 1. Par raison de symétrie, ces différences de niveaux obtenues dans le premier quadrant de la variable angulaire se retrouvent identiques au signe près dans les trois autres. Elles s'ajoutent successivement dans les zones croissantes de la fonction sinusoïdale et se retranchent de même dans les zones décroissantes suivant les seize niveaux d'échantillonnage répartis sur une période, de manière à restituer une variation approchée de la fonction.

2

**Tableau**

| K | $\sin(\Pi/16 + K \; \Pi/8)$ | Niveau calculé | Niveau synthétisé |
|---|---|---|---|
| 0 | 0,195 | 6,5 | 6,5 |
| 1 | 0,555 | 18,5 | 18,5 |
| 2 | 0,831 | 27,9 | 27,5 |
| 3 | 0,950 | 32,6 | 32,5 |

La figure 2 donne la variation en fonction du temps marqué par un signal d'horloge h des coefficients de pondédation a, b, c et d de la fonction définie ci-dessus. Chaque période du signal d'horloge correspond à une variation angulaire de $\pi/8$ entre deux niveaux consécutifs d'échantillonnage. Le signal f et son complément e sont utilisés pour affecter aux différences de niveaux synthétisés le signe + ou le signe - selon que la fonction sinusoïdale est croissante ou décroissante.

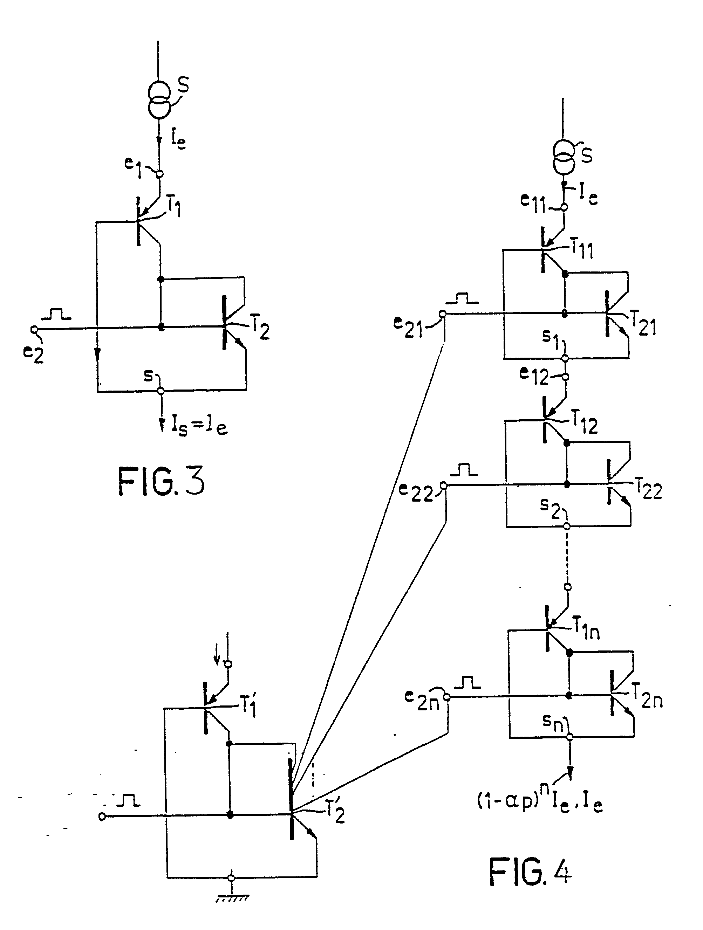

Sur la figure 3, la porte logique intégrée à injection de courant de type $I^2L$ comporte un transistor $T_1$ de type PNP et un transistor $T_2$ de type NPN, l'émetteur et le collecteur de $T_1$ étant constitués respectivement par deux zones P diffusées simultanément dans une zone épitaxiée N de manière à former un transistor latéral, ladite zone épitaxiée constituant la base de $T_1$ et l'émetteur de $T_2$. Le collecteur de $T_2$ est obtenu par une diffusion N+ dans la zone de collecteur P de $T_1$ qui constitue ainsi dans la partie sous-jacente à ladite diffusion N+, la zone de base de $T_2$.

Le courant $I_e$ d'une source de courant S reliee à l'entrée de signal $e_1$ sur l'émetteur de $T_1$ est égal au courant émetteur de ce dernier. Si le transistor $T_2$ a son collecteur rétrocouplé sur sa base, on a les relations de courants suivantes lorsqu'une commande logique appliquée à l'entrée $e_2$ du signal de commutation sur la base de $T_2$ rend ce dernier conducteur.

$$I_e = I_{E1} = I_{C1} + I_{B1}$$
$$I_{C1} = I_{C2} + I_{B2}$$

Si la porte $I^2L$ présente une sortie de signal s à l'interconnexion de la base de $T_1$ et de l'émetteur de $T_2$, le courant transmis en sortie de signal s est:

$$I_s = I_{B1} + I_{E2} = I_{B1} + I_{C2} + I_{B2} = I_{B1} + I_{C1} = I_{E1} = I_e$$ Le courant injecté à l'entrée de signal $e_1$ se retrouve donc transmis intégralement à la sortie de signal s, résultat intéressant si l'on se propose d'utiliser la porte $I^2L$ comme commutateur analogique de courant.

Lorsque ladite commande logique rend le transistor $T_2$ non conducteur, la partie du courant injecté constituée par le courant de collecteur $\alpha_p I_e$ de $T_1$ ($\alpha_p$ étant le gain en base commune) se retrouve dérivée vers l'entrée de signal de commutation $e_2$, tandis que l'autre partie du courant injecté constituée par le courant de base $(1 - \alpha_p)I_e$ de $T_1$ donne lieu à une transmission indésirable sur la sortie de signal s. Pour une valeur moyenne $\beta_p = 10$ du gain en courant d'un transistor PNP latéral ($\beta_p$ étant le gain en émetteur commun), ladite transmission indésirable est sensiblement égale au dixième du courant injecté, ce qui dans l'utilisation d'un tel élément commutateur pour la réalisation de convertisseurs numériques-analogiques fausse notablement les grandeurs analogiques correspondant aux faibles poids du signal numérique.

Une autre variante de commutateur schématisée sur la figure 4 consiste en la mise en cascade de n éléments commutateurs identiques conformes au schéma de la figure 3.

Cette technique dite d'empilage est bien connue et décrite dans les articles de W. UMKEHRER et al. dans SIEMENS FORSCHUNGS & ENTWICKLUNGS-BERCHTE, vol. 9, N°1, 1980 et de KENJI KANEKO et al. dans IEEE JOURNAL OF SOLID-STATE CIRCUITS, avril 1977, p. 210-212. La disposition de n couches $I^2L$ empilées permet une réduction de la puissance dissipée dans le rapport 1/n lorsque les circuits $I^2L$ sont utilisés avec d'autres circuits (par exemple des TTL) nécessitant des tensions d'alimentation plus élevées.

Cette disposition est proposée pour réduire ladite transmission indésirable du courant base de transistor injecteur $T_1$ dans l'état non conducteur du transistor commutateur $T_2$.

Chaque élément i a son entrée de signal $e_{1i}$ réliée à la sortie de signal $s_{i-1}$ de l'élément précédent, l'entrée de signal se trouvant sur l'entrée de signal $e_{11}$ du premier élément et la sortie du signal sur la sortie de signal $s_n$ du $n^{me}$ élément. Les n sorties de signal de commutation $e_{21}$, $e_{22}$,..., $e_n$ reçoivent simultanément la même valeur de signal transmise à chacune d'elles par l'intermediaire d'une porte logique qui peut être par exemple la porte logique intégrée à injection de courant de type $I^2L$ décrite dans le brevet français cité, constituée par le transistor injecteur $T'_1$ et le transistor commutateur $T'_2$, ce dernier comportant n + 1 collecteurs. Ainsi dans l'état conducteur des n transistors commutateurs, le courant injecté $I_e$ est intégralement transmis en sortie de signal tandis que dans leur état non conducteur, le signal indésirable transmis a pour valeur $(1-\alpha_p)^n I_e$. La mise en cascade de trois éléments commutateurs réduit le signal indésirable dans le rapport 120. Il faut noter que les n éléments commutateurs $I^2L$ doivent être réalisés dans des caissons isolés les uns des autres.

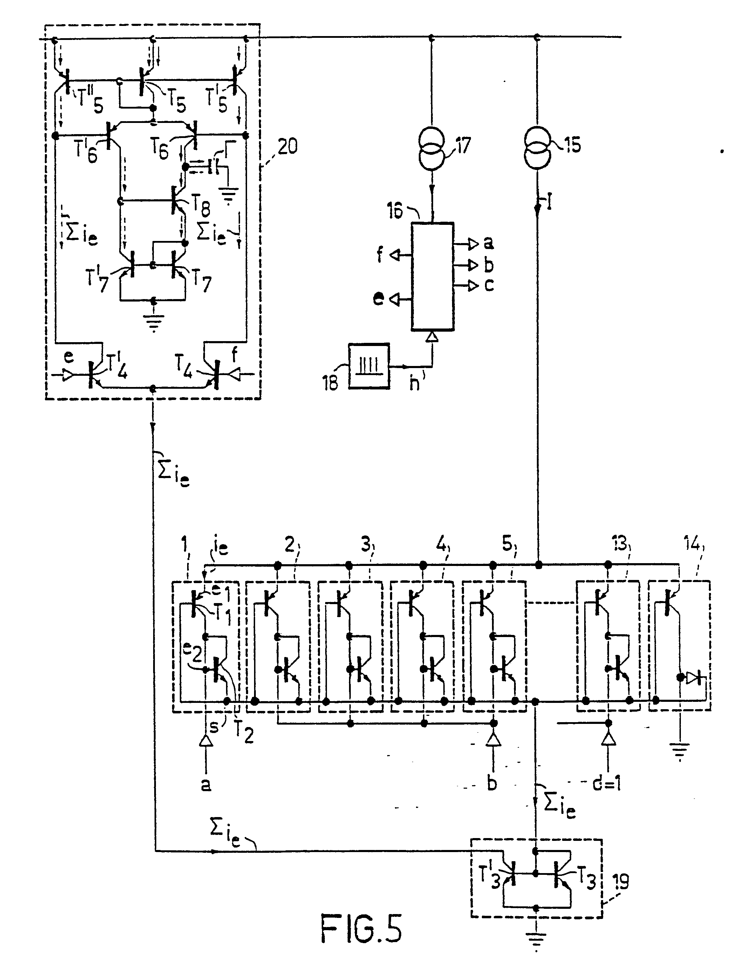

Le générateur de fonction conforme à l'invention est schématisé sur la figure 5. Une source de courant 15 alimente un ensemble d'éléments commutateurs identiques conformes au schéma de la figure 3. Les entrées

de signal $e_1$ de chaque élément commutateur sont interconnectées sur la source de courant 15 de telle sorte que le courant I fourni par cette source se partage également entre les entrées de signal de chaque élément commutateur qui reçoivent chacune un courant $i_e$. Le dispositif logique I²L 16 alimenté par la source de courant 17 et piloté par le signal d'horloge h issu du générateur d'horloge 18 élabore en fonction du temps les variations des coefficients de pondération et des signaux complémentaires e et f. Dans le cas de la fonction sinusoïdale dont lesdites variations sont représentées sur la figure 2, le nombre d'éléments commutateurs est de 14. L'élément commutateur 1 a son entréede signal de commutation $e_2$ reliée au dispositif logique 16 qui lui applique le signal a. Les éléments commutateurs 2 à 13 sont constitués en trois groupes de quatre, chacun d'eux ayant ses entrées de signal de commutation $e_2$ interconnectées et le dispositif logique 16 appliquant respectivement aux premier et deuxième groupes d'entrée $e_2$ ainsi formés les signaux b et c, tandis qu'un niveau constant d = 1 est appliqué au troisième groupe. Le commutateur 14 non utilisé mais technologiquement implanté avec le précédent est neutralisé en reliant directement à la masse son entrée de signal de commutation. Les sorties de signal s des commutateurs 1 à 14 sont de même interconnectées de manière à recueillir la somme pondérée des courants $\Sigma i_e = a.i_e + b.4i_e + c.4i_e + d.4i_e$ proportionnelle à la fonction sinusoïdale définie ci-dessus. A chaque combinaison des coefficients de pondération a, b, c et d correspond donc la différence de deux niveaux synthétisés consécutifs. On obtient ainsi successivement les valeurs $13i_e$, $12i_e$, $9i_e$ et $5i_e$ correspondant à une variation angulaire par pas de $\pi/8$ dans le premier quadrant de la variable où la fonction sinusoïdale est croissante. Lorsque cette fonction devient décroissante dans les second et troisième quadrants, on retrouve les mêmes valeurs de différences de niveaux synthétisés mais affectées du signe moins. On les retrouve encore mais affectées du signe plus lorsque la fonction redevient croissante dans le quatrième quadrant.

Afin d'opérer la transformation de $\Sigma i_e$ en $\pm \Sigma E i_e$, la somme pondérée des courants traverse d'abord un circuit intermédiaire 19 qui sous la forme représentée est un miroir de courant constitué par la paire de transistors $T_3$-$T'_3$ connectée comme l'indique la figure. La somme $\Sigma i_e$ est transmise ensuite par le collecteur du transistor $T'_3$ sur les émetteurs interconnectés de la paire de transistors $T_4$-$T'_4$ appartenant au circuit 20 qui fonctionne de la façon suivante. Lorsque la différence entre deux niveaux synthétisés consécutifs est positive, le signal f est appliqué sur la base du transistor $T_4$ de façon à le rendre conducteur et le signal e sur la base du transistor $T'_4$ de façon à le rendre non conducteur. Par le jeu de miroir de courant formé par les transistors $T_5$ et $T'_5$, la somme pondérée des courants $\Sigma i_e$ circule suivant les flèches indiquées en trait plein à travers les transistors $T'_5$, $T_5$ et le transistor $T_6$ de la paire $T_6$-$T'_6$ dont les émetteurs sont interconnectés et reliés au collecteur de $T_5$. De même, lorsque la différence entre deux niveaux synthétisés consécutifs est négative, le signal e rend $T'_4$ passant, tandis que le signal f bloque $T_4$. Par le jeu de miroir de courant formé par les transistors $T_5$ et $T''_5$, $\Sigma i_e$ circule suivant les flèches indiquées en pointillés à travers les transistors $T''_5$, $T_5$, $T'_6$ et grâce au miroir de courant formé par la paire de transistors $T_7$-$T'_7$ à travers le transistor $T_8$. On remarque que les flèches en trait plein et en pointillés sont en sens inverse aux bornes du condensateur T connecté entre la masse et le point commun aux collecteurs des transistors $T_6$ et $T_8$, ce qui réalise bien le changement de signe escompté lorsque la sommation des différences de niveaux synthétisés successives

$$\sum_{k = 1}^{16} (\Sigma i_e)_k$$

effectuée aux bornes de ce condensateur reconstitue la grandeur analogique, k étant un entier compris entre 1 et le nombre de niveaux d'échantillonnage répartis sur une période de la fonction sinusoïdale.

**Revendications**

1. Générateur de fonction dans lequel les niveaux successifs d'échantillonnage synthétisés sont approximés à partir des niveaux calculés multipliés par un certain facteur pour que les différences successives desdits niveaux synthétisés aient pour valeurs des nombres entiers aisément reproduits par une fonction alphanumérique dont les coefficients de pondération littéraux peuvent prendre les valeurs 0 et/ou 1, lesdites différences de niveau s'ajoutant successivement dans les zones croissantes de la fonction et se retranchant dans les zones décroissantes de manière à reconstituer une variation approchée de ladite fonction, caractérisé en ce que ledit générateur de fonction est réalisé au moyen d'un convertisseur numérique-analogique constitué d'un ensemble d'éléments commutateurs analogiques de courant identiques (1 à 13) dont les entrées de signal sont interconnectées sur une source unique de courant I de sorte que chacun d'eux reçoit le courant $i_e$, ledit convertisseur recevant les signaux de variation en fonction du temps (a, b, c, d) desdits coefficients de pondération et fournissant sur les sorties de signal interconnectées desdits commutateurs la somme pondérée des courants $i_e$ proportionnelle auxdites différences des niveaux synthétisés, ladite somme pondérée étant transmise à un circuit de transformation (20) qui reçoit des signaux (e, f) pour l'affecter des signes + ou - selon que la différence entre deux niveaux synthétisés consécutifs est positive ou négative, la sommation des sommes pondérées successives $\Sigma(\pm \Sigma i_e)$ étant effectuée aux bornes d'une charge capacitive ($\Gamma$) pour

reconstituer un signal analogique proportionnel à ladite fonction.

2. Générateur de fonction selon la revendication 1, caractérisé en ce que lesdits éléments commutateurs analogiques de courant sont des portes I2L dans lesquelles le transistor commutateur a son collecteur rétrocouplé sur sa base, l'entrée de signal étant sur l'émetteur du transistor injecteur ($T_1$) et la sortie de signal à l'interconnexion de la base du transistor injecteur et de l'émetteur du transistor commutateur ($T_2$).

3. Générateur de fonction selon l'une des revendications 1 à 2, caractérisé en ce qu'un dispositif logique (16) piloté par un signal d'horloge (18) dont chaque période correspond à la variation entre deux niveaux consécutifs d'échantillonnage, élabore lesdits signaux (a, b, c, d) des variations en fonction du temps desdits coefficients de pondération ainsi que lesdits signaux (c, f) transmis audit circuit de transformation (20) pour affecter le signe + ou le signe - à ladite somme pondérée des courants.

4. Générateur de fonction selon la revendication 3, caractérisé en ce que lesdits éléments commutateurs sont constitués en groupes de un ou plusieurs éléments, chacun desdits groupes ayant les entrées de signal de commutation desdits commutateurs c'est-à-dire les bases des transistors commutateurs interconnectées et ledit dispositif logique appliquant respectivement aux entrées de groupes ainsi formées, les signaux de variation en fonction du temps des coefficients de pondération.

5. Générateur de fonction selon l'une des revendications 1 à 4, caractérisé en ce que ladite somme pondérée des courants $\Sigma i_e$ est transmise par l'intermédiaire du miroir de courant $T_3$-$T'_3$ audit circuit de transformation (20) sur les émetteurs interconnectés de la paire de transistors $T_4$-$T'_4$ dont les bases reçoivent respectivement lesdits signaux f et e et dont les collecteurs sont reliés respectivement aux sorties des miroirs de courant $T_5$-$T'_5$ et $T_5T''_5$, la paire de transistors $T_6$-$T'_6$ ayant ses émetteurs interconnectés sur le collecteur de $T_5$ à l'entrée commune desdits miroirs et ses bornes reliées respectivement à leurs sorties, le miroir de courant $T_7$-$T'_7$ dont les émetteurs sont à la masse ayant sa sortie reliée au collecteur de $T'_6$ et son entrée reliée au collecteur de $T_6$ à travers l'émetteur et le collecteur d'un transistor $T_8$ dont la base est réunie aux collecteurs de $T'_6$ et $T'_7$, un condensateur ($\Gamma$) étant connecté entre le collecteur de $T_8$ et la masse.


**Patentansprüche**

1. Funktionsgenerator, in dem die aufeinanderfolgenden, synthetisierten Abtastpegel ausgehend von den berechneten und mit einem bestimmten Faktor multiplizierten Pegeln angenähert werden, damit die aufeinanderfolgenden Unterschiede dieser angenäherten Pegel als Werte durch eine alphanumerische Funktion leicht reproduzierte Ganzzahlen haben, und die Buchstaben-Gewichtungskoeffizienten dieser alphanumerischen Funktion können dabei die Werte 0 und/oder 1 annehmen, wobei diese Unterschiede im Pegel nacheinander in die wachsenden Funktionszonen aufgenommen und zur Wiederherstellung einer angenäherten Abwandlung dieser Funktion in den kleiner werdenden Zonen subtrahiert werden, dadurch gekennzeichnet, dass der Funktionsgenerator mit Hilfe eines Digital/Analog-Wandlers verwirklicht ist, der aus einer Anzahl gleicher analogischer Schaltelemente (1...13) besteht, deren Signaleingänge derart miteinander an eine Stromquelle I angeschlossen sind, dass jedes Element den Strom $i_e$ empfängt, wobei der Wandler die zeitabhängigen Schwankungssignale (a, b, c, d) der Gewichtungskoeffizienten empfängt und den miteinander verbundenen Signalausgängen der genannten Schalter die gewichtete Summe der Ströme $i_e$ proportional den synthetisierten Pegelunterschieden zuführt, wobei die gewichtete Summe auf eine Transformationsschaltung (20) übertragen wird, die Signale (e, f) zum Beeinflussen der Vorzeichen + oder - in Übereinstimmung damit empfängt, ob der Unterschied zwischen zwei aufeinanderfolgenden synthetisierten Pegeln positiv oder negativ ist, wobei die Summierung der aufeinanderfolgenden gewichteten Summen $\Sigma$ ($\pm \beta i_e$) an den Klemmen einer kapazitiven Belastung $\Gamma$ zum Wiederherstellen eines der genannten Funktion proportionalen analogischen Signals erfolgt.

2. Funktionsgenerator nach Anspruch 1, dadurch gekennzeichnet, dass die erwähnten analogischen Stromschaltelemente I2L-Gatter sind, in denen der Kollektor des Schalttransistors nach seiner Basis zurückgekoppelt ist, wobei sich der Signaleingang am Emitter des Injektionstransistor ($T_1$) und der Signalausgang an der Zusammenschaltung der Basis des Injektionstransistors und des Emitters des Schalttransistors ($T_2$) befinden.

3. Funktionsgenerator nach einem der Ansprüche 1 oder 2, dadurch gekennzeichnet, dass ein von einem Taktsignal (18) gesteuerten Baustein (16), wobei jede periode des Taktsignals der Schwankung zwischen zwei aufeinanderfolgenden Abtastpegeln entspricht, die Signale (a, b, c, d) der zeitabhängigen Schwankungen der Gewichtungskoeffizienten sowie die auf die Transformationsschaltung (20) zum Beeinflussen des Vorzeichens + oder des Vorzeichens - der genannten gewichteten Stromsumme übertragenen Signale (c, f) bearbeitet.

4. Funktionsgenerator nach Anspruch 3, dadurch gekennzeichnet, dass die Schaltelemente aus Gruppen von einem oder mehreren Elementen bestehen, wobei in jeder Gruppe die Eingänge der Schaltsignale der Schalter, d.h. die Basen der Schalttransistoren, miteinander verbunden sind, und dass der logische Baustein jeweils den so gebildeten Eingängen der Gruppen die zeitabhängigen Schwankungssignale der Gewichtungskoeffizienten zuführt.

5. Funktionsgenerator nach einem der Ansprüche 1 bis 4, dadurch gekennzeichnet, dass die gewichtete Summe $\Sigma i_e$ der Ströme über einen Stromspiegel $T_3$-$T'_3$ an der Transformationsschaltung (20) auf die miteinander verbundenen Emitter des Transistorpaares $T_4$-$T'_4$ übertragen wird, an deren Basen die Signale f bzw. e ankommen und deren Kollektoren an die Ausgänge der Stromspiegel $T_5$-$T'_5$ bzw. $T_5$-$T''_5$ angeschlossen sind, wobei die Emitter des Transistorpaares $T_6$-$T'_6$ am Kollektor von $T_5$ beim gemeinsamen Eingang der erwähnten Spiegel miteinander und die Klemmen mit ihren Ausgängen verbunden sind, wobei der Stromspiegel $T_7$-$T'_7$, dessen Emitter an Masse liegen, mit seinem Ausgang an den Kollektor von $T'_6$ und sein Eingang über den Emitter und den Kollektor eines Transistors $T_8$ an den Kollektor von $T_6$ angeschlossen sind, wobei die Basis des Transistor $T_8$ mit den Kollektoren von $T'_6$ und $T'_7$ verbunden ist, und ein Kondensator ($\Gamma$) zwischen dem Kollektor von $T_8$ und Masse angeschlossen ist.

## Claims

1. A function generator in which the successive synthesized sampling levels are approximated on the basis of calculated levels which are multiplied by a given factor in order to ensure that the successive differences between said synthesized levels take values in the form of integer numbers which can be readily reproduced by an alphanumerical function whose letter weighting coefficients can assume the values 0 and/or 1, said level differences being successively summed in the ascending zones of the function and being subtracted in the descending zones in order to approximate a variation of said function, characterized in that said function generator is constructed by means of digital-to-analog converter which is formed by an array of identical analog current switching elements (1 to 13) whose signal inputs are interconnected at a single current source I so that each input receives the current $i_e$, said converter receiving the signals representing the variation as a function of time (a, b, c, d) of said weighting coefficients and supplying, on the interconnected signal outputs of said switches, the weighted sum of the currents $i_e$ which is proportional to said differences between the synthesized levels, said weighted sum being applied to a transformation circuit (20) which receives signals (e, f) in order to assign thereto the sign + or -, depending on whether the difference between two successive synthesized levels is positive or negative, the summing of the successive weighted sums $\Sigma(\pm\Sigma i_e)$ taking place on the terminals of a capacitive load ($\Gamma$) reconstruct an analog signal which is proportional to said function.

2. A function generator as claimed in Claim 1, characterized in that said analog current switching elements are formed by $I^2L$ gates in which the collector of the switching transistor is coupled to its base, the signal input being formed by the emitter of the injection transistor ($T_1$) and the signal output being formed by the junction of the base of the injection transistor and the emitter of the switching transistor ($T_2$).

3. A function generator as claimed in Claim 1 or 2, characterized in that a logic device (16) which is controlled by a clock signal (18) whose periods correspond to the variation between two successive sampling levels, processes said signals (a, b, c, d) representing the variation as a function of time of said weighting coefficients as well as said signals (e, f) applied to said transformation circuit (20) in order to assign a + sign or a - sign to said weighted sum of the currents.

4. A function generator as claimed in Claim 3, characterized in that said switching elements form groups of one or more elements, the switching signal inputs of said switches of each group, i.e. the bases of the switching transistors, being interconnected and said logic device applying the signals representing the variation as a function of time of the weighting coefficients to the inputs of the groups thus formed.

5. A function generator as claimed in any one of the Claims 1 to 4, characterized in that said weighted sum of the currents $\Sigma i_e$ is applied, via the current mirror $T_3$ - $T'_3$, to said transformation circuit (20) at the interconnected emitters of the pair of transistors $T_4$ - $T'_4$ whose bases receive the signals f and e, respectively, and whose collectors are connected to the outputs of the current mirrors $T_5$ - $T'_5$ and $T_5$ - $T''_5$, respectively, the emitters of the pair of transistors $T_6$ - $T'_6$ being connected to the collector of $T_5$ at the common input of said mirrors, whilst its terminals are connected to the outputs thereof, the current mirror $T_7$ - $T'_7$ whose emitters are connected to ground having its output connected to the collector of $T'_6$ and its input to the collector of $T_6$ via the emitter and the collector of a transistor $T_8$ whose base is connected to the collectors of $T'_6$ an $T'_7$, a capacitor ($\Gamma$) being connected between the collector of $T_8$ and ground.

0 070 063

FIG.1

FIG.2

FIG.3

FIG.4

FIG.5